(19) Europäisches Patentamt
European Patent Office
Office européen des brevets

(11) Veröffentlichungsnummer: **0 676 626 A1**

## (12) EUROPÄISCHE PATENTANMELDUNG

(21) Anmeldenummer: **94810201.7**

(22) Anmeldetag: **11.04.94**

(51) Int. Cl.6: **G01J 1/46**, G01R 19/255, H03F 3/08

(43) Veröffentlichungstag der Anmeldung:
**11.10.95 Patentblatt 95/41**

(84) Benannte Vertragsstaaten:
**CH DE LI**

(71) Anmelder: **GRETAG Aktiengesellschaft**
**Althardstrasse 70**
**CH-8105 Regensdorf (CH)**

(72) Erfinder: **Guggenbühl, Walter, Prof Dr.**
**Glärnischstrasse 40**
**8712 Stäfa (CH)**

(74) Vertreter: **Kleewein, Walter, Dr. et al**
**Patentabteilung**
**CIBA-GEIGY AG**
**Postfach**
**CH-4002 Basel (CH)**

(54) **Vorrichtung zur Messung kleiner Ströme und Stromdifferenzen.**

(57) Eine Vorrichtung zur Messung kleiner Ströme und Stromdifferenzen umfasst einen Transistor, vorzugsweise einen Feldeffekttransistor (2), zwischen dessen Gateelektrode und einem festen Hilfspotential (4) eine Messkapazität (3) geschaltet ist. Der zu messende Strom wird dieser Messkapazität zugeführt und damit eine dem Stromintegral entsprechende Spannung erzeugt. Der Transistor (2), vorzugsweise ein Feldeffekttransistor vom MOS-Anreicherungstyp, wird an seiner Drainelektrode mittels einer Konstantstromquelle (5) gespeist. Das Potential der Gateelektrode wird mittels einer Rücksetzeinrichtung periodisch auf ein definiertes Potential, vorzugsweise auf das Potential der Drainelektrode zurückgesetzt, beispielsweise durch Schliessen eines zwischen der Gate- und der Drainelektrode des Transistors (2) geschalteten, vorzugsweise elektronisch ausgebildeten, Schalters (6) oder durch eine Reihenschaltung aus einem nichtinvertierenden Verstärker und einem vorzugsweise elektronisch ausgebildeten Schalter. Die Vorrichtung weist ferner einen Stromvergleicher (8) auf, der bei geöffnetem Schalter (6) den aus der Konstantstromquelle (5) minus dem Drainstrom ($i_D$) des Feldeffekttransistors (2) gebildeten Differenzstrom ($i_0$) mit einem Referenzstrom ($I_{Ref}$) aus einer Referenzstromquelle (R) vergleicht und so die Zeitspanne vom Rücksetzen der Gateelektrode bis zu dem Zeitpunkt misst, zu dem der Differenzstrom ($i_0$) den Wert des Referenzstroms ($I_{Ref}$) erreicht.

Fig. 1

Die Erfindung betrifft eine Vorrichtung zur Messung kleiner Ströme und Stromdifferenzen gemäss dem unabhängigen Patentanspruch.

Elektronische Anordnungen zur Messung kleiner Ströme sind hinlänglich bekannt. Sie beruhen meistens auf einem sog. Transimpedanzverstärker, d.h. einem Operationsverstärker mit einem grossen Widerstand im Rückkopplungspfad (siehe z.B. F. Bergtold "Schaltungen mit Operationsverstärkern Band II, Oldenbourg 1973 S. 108). Zur Messung kleiner Ströme sind extrem grosse Rückkopplungswiderstände erforderlich. Sie lassen sich nicht monolithisch integrieren, erzeugen relativ grosses Rauschen und verursachen bei starrer Montage ausserdem mikrophonische Störungen. Vor der Umwandlung der Messgrössen in Digitalsignale werden oft den Transimpedanzverstärkern nachgeschaltete integrierende Abtastkreise eingesetzt, die das Signal/Rauschverhältnis verbessern, bevor die eigentliche A/D-Wandlung stattfindet. Dies ist z.B. bei dem in der EP-A-0,331,629 beschriebenen Handgerät zur Erfassung optischer Remissionseigenschaften der Fall. Trotzdem bleibt die Grenzempfindlichkeit solcher Anordnungen noch weit unterhalb der durch die Photodiode gegebenen physikalischen Grenze.

Eine besser monolithisch integrierbare Anordnung verwendet als Eingangsschaltung einen elektronischen Integrator, d.h. einen Operationsverstärker mit einem rücksetzbaren Kondensator zwischen Ausgang und Eingang. Integration und eventuell nachfolgende Verstärkung der Ausgangsspannung sind hier gegenüber der vorgängig beschriebenen Methode vertauscht. Die Ausgangsspannung kann auf konventionelle Art in ein Digitalsignal umgewandelt werden. In vielen bezüglich Empfindlichkeit weniger anspruchsvollen Fällen ist eine zusätzliche Verstärkung des integrierten Signals unnötig. Das in der Eingangsstufe integrierte Signal wird dann direkt einem Fensterkomparator zugeführt und die Zeit, während der das Eingangssignal des Komparators innerhalb des eingestellten Fensters liegt, gemessen. Diese Zeit ist dann umgekehrt proportional zum zu messenden Strom. Dieses Konzept findet beispielsweise Anwendung im "Light to Frequency Converter" vom Typ TSL 200 der Firma Texas Instruments, bei welchem die Zeitmessung periodisch erfolgt und als Frequenz ausgegeben wird. Diese integrierte Schaltung arbeitet im Photostrombereich 18 nA bis 1,1 mA und entsprechenden Frequenzen von 2 Hz bis 130 kHz.

Der vorliegenden Erfindung liegt demnach die Aufgabe zugrunde, eine Vorrichtung zu schaffen, die es ermöglicht, noch kleinere Ströme zu messen und noch kürzere Auslesezeiten zuzulassen. Insbesondere soll die Vorrichtung in CMOS-Technik integrierbar zu realisieren sein, also auch ohne grosse Widerstände auskommen. Ausserdem soll sie ein ebenso gutes oder besseres Verhalten bezüglich des Signal/Rauschverhaltens aufweisen wie bekannte Anordnungen.

Diese Aufgabe wird erfindungsgemäss durch eine Vorrichtung gelöst, wie sie im des Patentanspruch 1 definiert ist. Vorteilhafte Ausbildungen der Vorrichtung ergeben sich aus den Unteransprüchen, insbesondere aus dem Unteranspruch, gemäss dem eine Photodiode als signalgebende Stromquelle eingesetzt wird.

Im folgenden wird die Erfindung mit Hilfe der Zeichnung näher erläutert. Dabei zeigen in schematischer Darstellung:

Fig. 1    ein Ausführungsbeispiel der erfindungsgemässen Vorrichtung,

Fig. 2    den zeitlichen Verlauf verschiedener Signale,

Fig. 3    das Ausführungsbeispiel gemäss Fig. 1 mit einer Korrekturstufe,

Fig. 4    ein weiteres Ausführungsbeipspiel der erfindungsgemässen Vorrichtung

Fig. 5    ein weiteres Ausführungsbeispiel der erfindungsgemässen Vorrichtung mit beleuchtungsproportionalem Eichstrom.

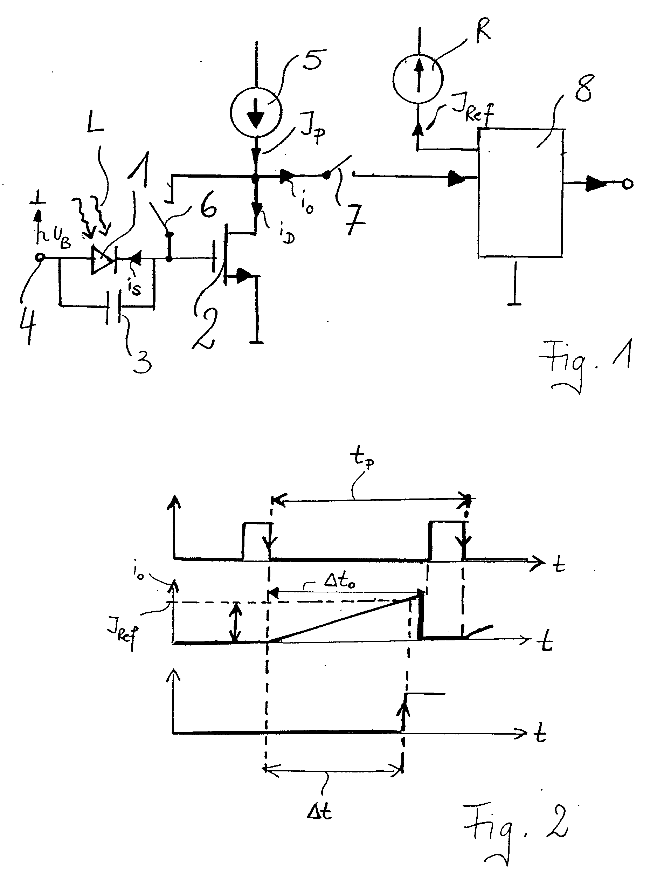

In Fig. 1 ist ein einfaches Ausführungsbeispiel der erfindungsmässigen Vorrichtung mit einer Photodiode als signalgebende Stromquelle und in Fig. 2 die zugehörigen zeitlichen Verläufe verschiedener Signale gezeigt. Das in Fig. 1 dargestellte Ausführungsbeispiel der Vorrichtung umfasst eine Photodiode 1, einen MOS-FET-Transistor 2 vom Anreicherungstyp, als Messkapazität einen Kondensator 3, eine Konstantspannungsquelle zur Erzeugung eines Hilfspotentials 4, eine Konstantstromquelle 5, sowie zwei Schalter 6 und 7. Ferner umfasst die Vorrichtung noch einen Stromvergleicher 8, an dessen einem Eingang eine Referenzstromquelle R angeschlossen ist.

Einfallendes Licht L als Signal erzeugt in der Photodiode 1, die auch gleichzeitig die Messkapazität bilden kann und separat zugeschaltet sein kann oder mit allen übrigen Elementen auf demselben Chip angeordnet sein kann, einen Photostrom $i_s$. Der zu messende Photostrom $i_s$ aus der mittels der Konstantspannungsquelle zur Erzeugung des Hilfspotentials 4 sperrpolarisierten Photodiode 1 wird auf dem Kondensator 3 integriert und in eine zeitabhängige Spannung an der Gateelektrode des Anreicherungs-MOSFET-Transistors 2 umgewandelt. Vorzugsweise wird die mittels der Quelle 4 angelegte Hilfsspannung $U_B$ gleich der Sourcespannung des Transistors 2 gewählt und als Kondensator 3 (Integrationskapazität) die Eigenkapazität der Photodiode 1 verwendet. Bei Belichtung der Photodiode 1 sinkt die Spannung am Gate des Transistors 2 als Folge der Entladung der Kapazität (Kondensator) 3 durch den Photostrom $i_S$ kontinuierlich ab; die dabei verlorene Ladung auf dem Kondensator 3 wird periodisch durch Schliessen des zwischen Dran und Gate des Transistors 2 liegenden Schalters 6 ersetzt (Periode $t_p$, siehe Zeitverlauf des Schaltersignals im obersten Zeitdiagramm in Fig. 2), indem die Konstantstromquelle 5 die Kapazität 3 auf die sich bei verbundener Drain- und Gateelektrode einstellende Gate-Spannung aufgeladen wird. Im Transistor 2 fliesst dann ein Drainstrom $i_D$, der gleich dem durch die Stromquelle 5 eingeprägtem Strom $I_P$ ist. Nach dem Oeffnen des Schalters 6 bleibt zunächst der Strom $I_P$ im Transistor 2 erhalten, und es beginnt der Integrationsprozess, d.h. die oben beschriebene Entladung der Kapazität 3 und ein entsprechender Abfall des Drainstroms $i_D$ im Transistor 2. Der Strom $i_o$ als Differenz des Stroms $I_P$ der Konstantstromquelle 5 und des Drainstroms $i_D$ nimmt entsprechend kontinuierlich zu, bis am Eingang des über den elektronischen Schalter 7 zugeschalteten Stromvergleichers 8 der Strom $i_o = I_{Ref}$ erreicht ist (siehe Zeitverlauf des Differenzstroms im mittleren Zeitdiagramm in Fig. 2). Die Zeit $\Delta t$ (siehe Zeitverlauf des Ausgangssignals des Stromvergleichers im untersten Zeitdiagramm in Fig. 2) vom Öffnen des (Rückstell-)Schalters 6 bis zur Stromgleichheit $i_o = I_{Ref}$ ist eine monoton abnehmende Funktion des Stromes $i_s$. Für kleine Signale $i_s$ wird der Ausgangsstrom

$$i_o \approx i_s \cdot g_m \cdot t / C_1 \qquad (1)$$

und die Zeit bis zum Erreichen des Referenzstroms $I_{Ref}$

$$\Delta t = I_{Ref} \cdot C_1 / g_m \qquad (2)$$

wobei $C_1$ die Kapazität 3 und $g_m$ die Steilheit des Transistors 2 bezeichnen. Wenn die Vorrichtung über grössere Temperaturbereiche gleichmässig arbeiten soll, so ist die Temperaturabhängigkeit der Steilhiet $g_m$ des Transistors 2 zu kompensieren. Verfahren dazu sind aus der Literatur bekannt, beispielsweise aus einem Artikel von F. Krummenacher, N. Joehl, "A 4Mhz CMOS Continous Time Filter with On Chip Automatic Tuning", IEEE Journal of Solid State Circuits, Vol. 23 No. 3, June 1988, Seiten 750-758.

Für grosse Signale bzw. lange Integrationszeiten ist jedoch als Folge der nichtlinearen Charakteristik des Drainstroms $i_D$ in Abhängigkeit von der Gate-Source-Spannung $U_{GS}$ (also $i_D = f(U_{GS})$ und der Nichtlinearität der Kapazität 3 der Photodiode 1 die Linearität zwischen dem Differenzstrom $i_o$ und dem integrierten Photostrom $i_s$ nicht gewährleistet. Eine absolute Messung der Photoströme ist deshalb auf kleine Photoströme ($i_s \ll I_P$) beschränkt.

Eine weniger eingeschränkte Situation ergibt sich bei der Messung von Stromverhältnissen, wie sie in vielen Anwendungen, z.B. bei Remissionsmessungen in der Farbmesstechnik vorkommen. Misst man nach dem erfindungsmässigen Verfahren hintereinander zwei verschiedene Signalströme, so spielen die erwähnten Nichtlinearitäten und Temperaturgänge keine Rolle. Einem Aufbau des Differenzstromes $i_o$ von 0 auf $I_{Ref}$ entspricht für beide Messungen auf der Kapazität 3 ein definierter durchlaufener Spannungsbereich zwischen zwei Potentialwerten der Gate-Sourcespannung, d.h. eine gleiche abgeführte Speicherladung, unabhängig von ihrer Aufteilung in Strom und Integrationszeit. Voraussetzung dazu ist, dass die Temperatur sich zwischen den betreffenden Messungen nicht ändert.

Daraus folgt für das Verhältnis der Zeiten $\Delta t_1$, $\Delta t_2$, die nacheinander gemessenen Strömen zugeordnet sind, die Beziehung

$$\Delta t_1 / \Delta t_2 = i_{s2} / i_{s1} \qquad (3)$$

unabhängig von den erwähnten Nichtlinearitäten.

Als Beispiel der Weiterverarbeitung solcher Messzeiten durch einen nachgeschalteten Digitalprozessor wird im folgenden die Berechnung eines Photostromwertes $i_{ph}$ relativ zu einem Eichstrom $i_E$ (siehe weiter unten).

In der Praxis der Photostrommessung kann dieses Verhältnis z.B. aus der Differenz zwischen Eichstrom allein und dem Eichstrom mit überlagertem Photostrom errechnet werden. Aus zwei aufeinanderfolgende Messungen, d.h. einer Messung mit $i_{s1} = i_E$ und $i_{s2} = i_E + i_{ph}$ ergibt sich für das Verhältnis des Photostromes zum Eichstrom

$$i_{ph} / i_E = (i_{s2} - i_{s1}) / i_{s1} = (\Delta t_1 - \Delta t_2) / \Delta t_2 \qquad (4)$$

Diese Messmethode von Stromdifferenzen ergibt für kleine Photoströme $i_{ph}/i_E \ll 1$ eine relativ hohe Dynamikauflösung. Der Eichstrom wird vorzugsweise der Photodiode 1 direkt aus einer Stromquelle zugeführt. Die für die Eichmessung massgebende Situation entspricht dann photometrisch einer Dunkelstrommessung.

Dem Fachmann ist bekannt, dass alle photometrischen Messungen auf Weiss bezogen werden. Dazu ist ein weiteres Messwertepaar notwendig, falls die Weissmessung nicht unmittelbar vor oder nach dem oben beschriebenen Messwertepaar $i_{s2}$, $i_{s1}$ Gl. (2), d.h. bei derselben Temperatur erfolgt. Bezeichnet man mit $\Delta tw$ das einer Weissmessung zugeordnete Zeitintervall und mit $\Delta t_{EW}$ dasjenige einer unmittelbar vor- oder nach der Weissmessung durchgeführten Messung mit dem Eichstrom, so gilt analog Gl. (3)

$$i_W / i_E = \Delta t_{EW} / \Delta t_W$$

und für das Verhältnis $i_{ph}/i_W$

$$i_{ph} / i_W = ((\Delta t_1 - \Delta t_2) / \Delta t_2) \cdot \Delta t_W / \Delta t_{EW} \qquad (5)$$

Dabei ist vorausgesetzt, dass der Eichstrom $I_E$ für beide Messwertepaare gleich ist.

Praktische Vorrichtungen gemäss Fig. 1 zeigen gegenüber dem beschriebenen Idealverhalten relativ grosse Fehler. Aus der Technik der sog. SI-Schaltungen (Switched Current Circuits, siehe z.B. T.S. Fiez, G. Liang, D.J. Allstot, "Switched Current Design Issues", IEEE Journal of Solid State Circuits, Vol. 26 No. 3, März 1991, Seiten 192-201) ist bekannt, dass die Genauigkeit abgetasteter Schaltungen, in denen die Signale durch Ströme dargestellt sind, durch Taktübersprechen, Rauschen und die Ausgangsleitwerte der eingesetzten Stromquellen begrenzt wird.

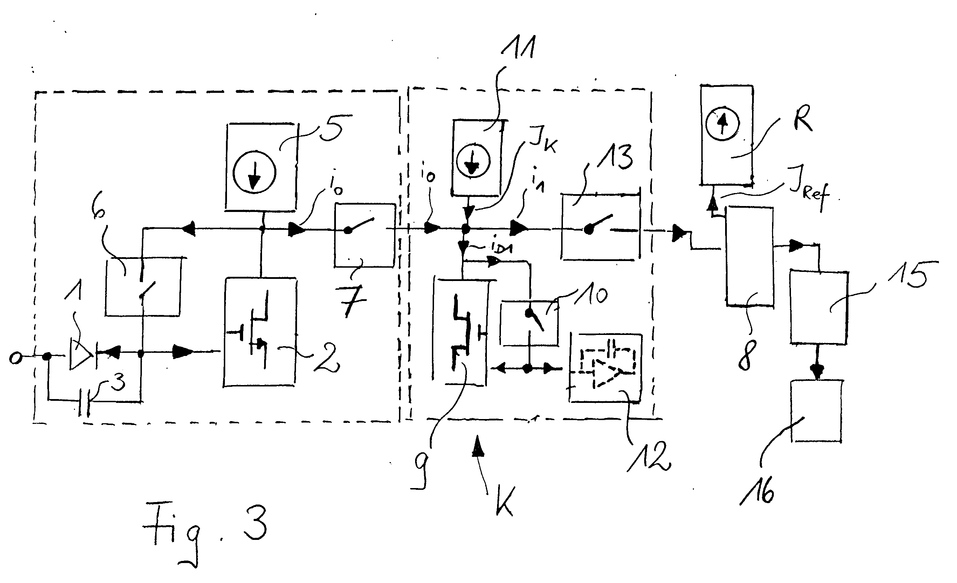

Da diese Art der Signaldarstellung auch in dem in Fig. 1 dargestellten Schaltungsprinzip verwendet wird, muss die Schaltung zur Erzielung der angestrebten hohen Genauigkeit gegenüber Fig. 1 erweitert und durch Fehlerkorrekturschaltungen ergänzt werden. Diese zusätzlichen Schaltungsmassnahmen werden anhand des Blockschaltbildes Fig. 3 beschrieben. Die Erweiterung besteht aus einer Gruppe von als Korrekturstufe K bezeichneten Schaltungsblöcken, bestehend aus Konstantstromquelle 11, einem weiteren als Speichertransistor fungierenden Feldeffekttransistor 9, einem Rückkopplungsschalter 10 und einem Transversalschalter 13. Optional wird noch eine elektronische Kapazitätsvergrösserungsschaltung 12 eingesetzt. Die Korrekturstufe K dient zur Korrektur des Nullpunktfehlers der in Fig. 1 beschriebenen Vorrichtung. Unter dem Nullpunktfehler ist dabei die Abweichung des Differenzstroms $i_o$ vom Sollwert (d.h. vom Wert $i_o = 0$ unmittelbar nach dem Oeffnen des Schalters 6) definiert.

Die Korrekturstufe K besteht im wesentlichen aus denselben Schaltungsteilen wie die anhand von Fig. 1 beschriebenen Schaltungsteile, d.h. sie leitet im sog. Trackmode (Schalter 7 und 10 geschlossen, Schalter 13 offen) den Strom $i_{D1} = i_o + I_K$ in den Speichertransistor 9, speichert seinen Wert zum Zeitpunkt $t_1$ des Öffnens des Schalters 10 als Drainstrom $i_{D1} (t_1)$ im Transistor 9 ab und führt bei nachfolgend geschlossenem Schalter 13 den Differenzstrom $i_1 = i_o(t) - i_o(t_1)$, also den um den Nullpunktsfehler korrigierten Strom der Vorrichtung gemäss Fig. 1 an den Stromvergleicher 8 weiter. Der so noch verbleibende Fehler am Eingang des Stromvergleichers 8 stammt primär aus der Korrekturstufe K. Da dieser viel kleiner (viel kleinere Steilheit $g_m$ des Transistors 9) ist als derjenige der Vorrichtung gemäss Fig. 1 (Taktübersprechen und Rauschen sind proportional zu $g_m$), ist der resultierende Fehler kleiner als bei direktem Vergleich des Referenzstroms $I_{Ref}$ aus der Konstantstromquelle R mit dem Strom $i_o$. Als Referenz für die Zeitintervallmessung $\Delta t$ gilt nun das Oeffnen des Schalters 10. Optional kann der Nullpunktfehler der Korrekturstufe K mit Hilfe einer Zusatzkapazität an der Gateelektrode des Speichertransistors 12 weiter verkleinert werden. In der Ausbildung der Fig. 3 wird diese Zusatzkapazität durch eine Einrichtung 12 zur Vergrösserung der Eingangskapazität mittels eines Verstärkers mit einer kleinen Kapazität zwischen seinem Ausgang und Eingang erzeugt. Dieses in der Elektronik als sog. Miller-Effekt bezeichnete Prinzip zur Kapazitätsvergrösserung ergibt flächenmässig bedeutend kleinere Kondensatoren als die Realisierung mit einem klassischen Pattenkondensator und bietet deshalb in der integrierten Schaltungstechnik vorteilhafte Lösungen.

Beispiele für Schaltungen für Stromvergleicher 8 sind zwei in Reihe geschaltete Stromquellen, von denen die eine konstant und die andere variabel ist. Das Potential des Verbindungspunkts der beiden Quellen springt dann bei Stromgleichheit. In dem dem Stromvergleicher 8 nachgeschalteten Analog-Digitalwandler 15 wird das oben erwähnte gemessene Zeitintervall in eine digitale Zahl umgewandelt, was vorzugsweise mittels eines Zählers erfolgt. Dieser Zähler zählt also quasi die Zeit zwischen dem Zeitpunkt, zu dem der Schalter 10 geöffnet wird zu dem Zeitpunkt, zu dem er einen Impuls vom Stromvergleicher 8 erhält, also der Strom $i_1$ den Wert $I_{Ref}$ erreicht. Die nachfolgende Umrechnung in weiterverwendbare, einem Stromverhältnis entsprechende, insbesondere auch in photometrische, Grössen auf bekannte Art und Weise erfolgt in einem digitalen Prozessor 16. Beispiele, auf welcher Basis solche Umrechnungen grundsätzlich vorgenommen werden können, sind in den Gleichungen (4) und (5) angegeben.

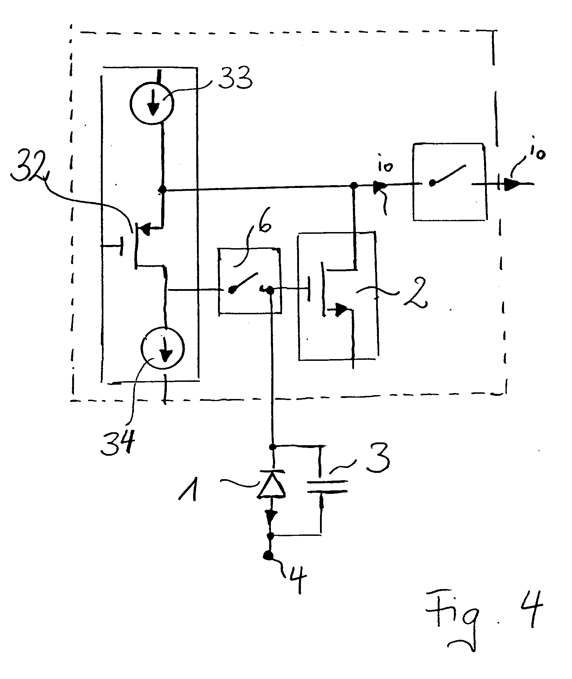

Zur Einhaltung hoher Präzisionsanforderungen sind kleine Ausgangsadmittanzen der Konstantstromquellen und Speichertransistoren notwendig. Die Konstantstromquellen 5,11,R und Speichertransistoren 2 und 9 sind deshalb gemäss einem weiteren Ausführungsbeispiel der erfindungsgemässen Vorrichtung vorzugsweise in der bekannten Kaskodetechnik ausgeführt. Eine Alternative zu kleinen Admittanzen ist die in dem Artikel von J.B. Hughes, K.W. Moulding, "Switched Current Signal Processing for Video Frequencies and Beyond", IEEE Journal of Solid State Circuits, Vol. 28 No. 3, März 1993, Seiten 314-322, vorgeschlagene Technik zur Konstanthaltung der Ausgangsspannung des Speichertransistors. Dies wird gemäss Fig. 4 über einen Hilfstransistor 32 in Gate-Schaltung sichergestellt und damit die Stromfehler von $i_1$ und $i_o$ (siehe Fig. 3) als Folge von Spannungsänderungen minimiert.

Die Konstantstromquellen 33 und 34 (Fig. 4) versorgen den Hilfstransistor 32 mit Arbeitsstrom. Sinngemäss kann das Ausführungsbeispiel der Vorrichtung gemäss Fig. 1 und die Korrekturstufe K gemäss Fig. 3 durch eine Anordnung gemäss Fig. 4 ersetzt werden, wobei im Fall des Ausführungsbeispiels gemäss Fig. 1 das Gate des Speichertransistors 2 (wie in Fig. 3 dargestellt), im Fall der Korrekturstufe K die Drainelektrode des Speichertransistors 9 als Eingang benutzt werden. Die Forderung nach Kaskodenstufen entfällt bei dieser Variante.

Eine zweite Fehlerquelle beim Kopieren und Vergleichen von Strömen ist das dem Fachmann bekannte Taktübersprechen, d.h. die beim Öffnen der Rückkopplungsschalter 6 und 10 in Fig. 1 und Fig. 3 auf die angeschlossenen Gatekapazitäten ausgestossene Schalterladung, die zu Fehlern des im Transistor gespeicherten gegenüber dem in der Trackphase eingelesenen Stroms führt.

Eine aus der Literatur bekannte Massnahme ist die Kompensation dieser Störladung durch einen zum jeweiligen Schalter in Reihe angeordneten sogenannten "Dummy"-Transistor. In einem vorteilhaften Ausführungsbeispiel der erfindungsgemässen Vorrichtung werden deshalb die Rückkopplungsschalter 6 und 10 durch solche "dummy-kompensierte" Schalter-Anordnungen ausgebildet.

Eine Variante der erfindungsgemässen Schaltung besteht darin, den Strom $I_{Ref}$ der Konstantstromquelle R der Vergleicherschaltung 8 durch "Einkopieren" eines entsprechenden Stromes in einen Stromspeicher zu realisieren. Der so gebildete Referenzstrom $I_{Ref}$ kann derart erzeugt werden, dass der Endwert des Differenzstroms $i_0$ bzw. $i_1$ am Ende eines Integrationszyklus der vorgegebenen Länge $\Delta t_0$, während dem auf dem Kondensator 3 der Signalstrom $i_s$ integriert wird, in einen Sromspeicher "einkopiert" wird.

Das "Einkopieren" des Endwerts von $i_0$ bzw. $i_1$ in einen solchen Stromspeicher (Stromquellentransistor) erfolgt analog zum Kopiervorgang des Differenzstroms in die Korrekturstufe K (Fig. 3). In einem, nachfolgenden Messzyklus, in dem der Eichstrom $i_E$ auf den Eingang der Schaltung geschaltet ist, wird der nun erzeugte Differenzstrom $i_1$ bzw. $i_0$ mit dem vorgängig gebildeten Referenzstrom $I_{Ref}$ verglichen und die Zeit $\Delta t$ gemessen. Nach der Gleichung

$$i_s \cdot \Delta t_0 = i_E \cdot \Delta t$$

folgt

$$i_s = i_E \cdot (\Delta t / \Delta t_0)$$

Dieses Messprozedere entspricht implizit dem aus der A/D-Wandlertechnik von Spannungen bekannten Doppelrampenprinzip, das hier mit den notwendigen wesentlichen Modifikationen im Strombereich realisiert ist. Wird während des ersten Messzyklus der Messstrom $i_s$ dem Eichstrom $i_E$ überlagert, so folgt aus überlagert, so folgt aus

$$(i_E + i_s) \cdot \Delta t_0 = i_E \cdot \Delta t$$
$$i_s = i_E \cdot (\Delta t - \Delta t_0) / \Delta t_0$$

Diese gemessenen Zeitintervalle können in bekannter Weise mittels Zählern in digitale Werte umgewandelt werden.

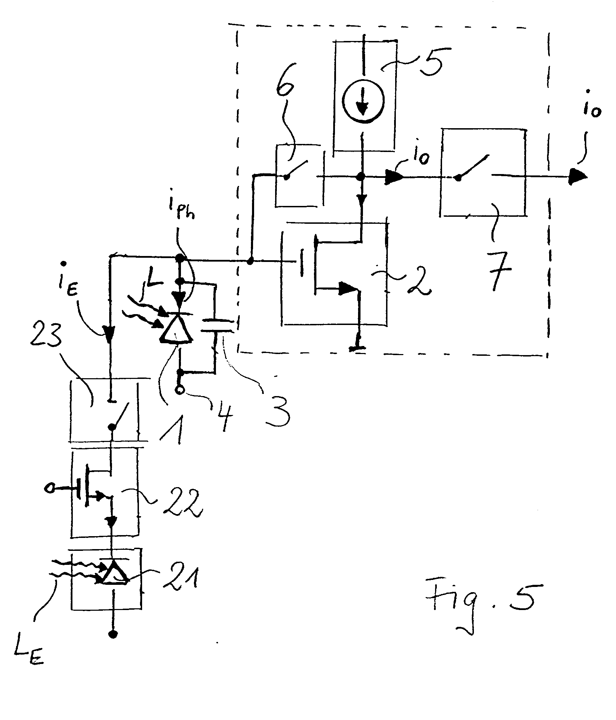

In Fig. 5 ist ein weiteres Ausführungsbeispiel der erfindungsgemässen Vorrichtung dargestellt, aus der das Messprinzip, insbesondere bei Anwendung auf Remissions- und Dichtemessungen, ersichtlich ist. Auf diesem Anwendungsgebiet wird oft, wie beschrieben, mit einer Sequenz von Dunkelstromeichung und nachfolgender Messung gearbeitet. Dabei wird zur Dynamikvergrösserung zusätzlich zum Dunkelstrom ein Eichsignal an den Eingang des Analog/Digital-Wandlers geschaltet, dem in einem nachfolgenden Messzyklus die zu messende Grösse überlagert wird. Ein solches Prinzip ist für die Verarbeitung von Spannungen in der EP-A-0,331 ,629 (Seite 7, Zeilen 25-43) beschrieben und dient zur Erfüllung der hohen Forderungen nach Dynamik und Genauigkeit. Fig. 5 zeigt eine besonders effiziente Ausbildung der Methode im Strombereich. Die Addition des entsprechenden Eichstroms erfolgt im Unterschied zur genannten EP-A-0,331,629 im Eingangskreis der Messschaltung, d.h. an der Photodiode 1. Macht man diesen Eichstrom z.B. durch direkte Ableitung proportional zur Beleuchtungsquelle, so können Lampenschwankungen weitgehend kompensiert werden.

Anhand Fig. 5 sind zwei Ausbildungsformen zur Ueberlagerung eines beleuchtungsproportionalen Stroms zum zu messenden Lichtstrom ersichtlich:

In einer ersten Variante wird das Eichlicht aus der Beleuchtungsquelle abgezweigt und über einen direkten optischen Pfad der Messphotodiode, z.B. über eine Glasfaser, zugeführt. Die Proportionalität aller Ströme in Gleichung (4) zu den Lampenschwankungen sorgt in vielen Fällen für die Kompensation dieser Störung.

Eine zweite Variante zur Zuführung eines beleuchtungsproportionalen Vorstroms arbeitet gemäss Fig. 5. Ist die direkte optische Zuführung eines beleuchtungsproportionalen Lichtanteils auf die Photodiode 1 aus konstruktiven Gründen unerwünscht, kann der entsprechende Eichstrom, erzeugt mit Hilfe von Eichlicht $L_E$, welches eine Hilfsphotodiode 21 beaufschlagt, über den "Dummy"-Transistor 22 und den Schalter 23 der Photodiode 1 zugeführt werden. Diese Einspeiseschaltung kann mehrfach auf demselben Chip ausgeführt zur Versorgung einer ganzen (Mess)-Photodiodenzeile eingesetzt werden.

**Patentansprüche**

1. Vorrichtung zur Messung kleiner Ströme und Stromdifferenzen, mit einem Transistor, vorzugsweise einen Feldeffekttransistor (2), zwischen dessen Gateelektrode und einem festen Hilfspotential (4) eine Messkapazität (3) geschaltet ist, und bei der der zu messende Strom dieser Messkapazität zugeführt und damit eine dem Stromintegral entsprechende Spannung erzeugt wird, bei welcher Vorrichtung der Transistor (2), vorzugsweise ein Feldeffekttransistor vom MOS-Anreicherungstyp, an seiner Drainelektrode mittels einer Konstantstromquelle (5) gespeist wird, mit einer Rücksetzeinrichtung, die das Potential der Gateelektrode periodisch auf ein definiertes Potential, vorzugsweise auf das Potential der Drainelektrode, zurücksetzt, beispielsweise durch Schliessen eines zwischen der Gate- und der Drainelektrode des Transistors (2) geschalteten, vorzugsweise elektronisch ausgebildeten, Schalters (6) oder durch eine Reihenschaltung aus einem nichtinvertierenden Verstärker und einem vorzugsweise elektronisch ausgebildeten Schalter, ferner mit einem Stromvergleicher (8), der bei geöffnetem Schalter (6) den aus der Konstantstromquelle (5) minus dem Drainstrom ($i_D$) des Feldeffekttransistors (2) gebildeten Differenzstrom ($i_0$) mit einem Referenzstrom ($I_{Ref}$) aus einer Referenzstromquelle (R) vergleicht und so die Zeitspanne vom Rücksetzen der Gateelektrode bis zu dem Zeitpunkt misst, zu dem der Differenzstrom ($i_0$) den Wert des Referenzstroms ($I_{Ref}$) erreicht.

2. Vorrichtung nach Anspruch 1, dadurch gekennzeichnet, dass der Transistor (2) als Kaskodestufe und die Konstantstromquelle (5) und/oder die Referenzstromquelle (R) als Kaskoden-Stromspiegel ausgebildet ist.

3. Vorrichtung nach einem der Ansprüche 1 oder 2, dadurch gekennzeichnet, dass sie eine separat zugeschaltete Photodiode (1) umfasst, die den zu messenden Strom ($i_s$) erzeugt und die gleichzeitig auch die Messkapazität (3) bildet.

4. Vorrichtung nach einem der Ansprüche 1 oder 2, dadurch gekennzeichnet, dass sie eine Photodiode (1) umfasst, die den zu messenden Strom ($i_s$) erzeugt, und dass die Photodiode (1) und die übrigen Elemente alle auf einem Chip angeordnet sind.

5. Vorrichtung nach einem der Ansprüche 1 bis 4, dadurch gekennzeichnet, dass der Messkapazität (3) die Summe aus einem definierten Vorstrom bzw. Eichstrom ($i_E$) und dem zu messenden Strom ($i_{ph}$) zugeführt sind.

6. Vorrichtung nach Anspruch 5, dadurch gekennzeichnet, dass zur Erzeugung des Vorstroms bzw. Eichstroms die Photodiode (1) additiv zum Messlicht (L) mit Referenzlicht ($L_E$) beaufschlagt wird oder dass eine separate Hilfsphotodiode (21) vorgesehen ist, die von derselben Lichtquelle beaufschlagt wird wie die Photodiode (1).

7. Vorrichtung nach Anspruch 6, dadurch gekennzeichnet, dass mehrere Hilfsphotodioden zur Erzeugung des Vorstroms für mehrere Photodioden vorgesehen sind, dass diese Hilfsphotodioden auf einem gemeinsamen Chip angeordnet sind, und dass jeder Hilfsphotodiode (21) ein vorzugsweise elektronischer Schalter (23) nachgeschaltet ist.

8. Vorrichtung nach einem der Ansprüche 1 bis 7 dadurch gekennzeichnet, dass sie eine Korrekturstufe (K) zur Kompensation des Nullpunktfehlers des Transistors (2) nach Oeffnen des Rücksetzschalters (6) aufweist.

9. Vorrichtung nach Anspruch 8 dadurch gekennzeichnet, dass die Korrekturstufe eine separate Konstantstromquelle (11) aufweist, sowie einen separaten Transistor (9), vorzugsweise einen Feldeffekttransistor, zwischen dessen Drainelektrode und Gateelektrode ein Schalter (10) angeordnet ist und dessen Gateelektrode eine Einrichtung (12) zur Vergrösserung der Eingangskapazität zugeschaltet ist.

10. Vorrichtungnach einem der Ansprüche 1 bis 9, dadurch gekennzeichnet, dass die Schalter (6,10,23) als MOS-Schalter ausgebildet sind, denen jeweils ein Dummy-Transistor (22) vorgeschaltet ist.

11. Vorrichtung nach einem der Ansprüche 1 bis 10, dadurch gekennzeichnet, dass der Referenzstrom ($I_{Ref}$) durch Integration des Differenzstroms ($i_0$) während der Zeitdauer, in der in dem vorangehenden Stromintegrationszyklus der Strom durch die Photodiode (1) integriert wird, erzeugt wird, und dass der am Ende des Stromintegrationszyklus durch Integration gewonnene Wert als Referenzstrom ($I_{Ref}$) für den nachfolgenden Stromintegrationszyklus dem Stromvergleicher (8) zugeführt ist.

12. Vorrichtung nach einem der Ansprüche 1 bis 11, dadurch gekennzeichnet, dass das Ausgangssignal des Stromvergleichers einem Analog/Digitalwandler (15) zugeführt ist, der die Zeit zwischen dem Öffnen des Rücksetzschalters (6) zwischen Gateelektrode und Drainelektrode und dem Zeitpunkt, zu dem der Differenzstrom ($i_0$) den Wert des Referenzstroms ($I_{Ref}$) erreicht, ermittelt und ein entsprechendes Signal einem Digitalprozessor (16) zuführt, der dieses weiterverarbeitet, insbesondere photometrischen Grössen daraus ermittelt.

EP 0 676 626 A1

Fig. 1

Fig. 2

Fig. 3

EP 0 676 626 A1

Fig. 4

Fig. 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| A | GB-A-1 257 943 (MARCONI) <br> * Abbildungen 1-3 * <br> --- | 1 | G01J1/46 <br> G01R19/255 <br> H03F3/08 |
| A | ELECTRONICS LETTERS, <br> Bd.29, Nr.2, Januar 1993, STEVENAGE GB <br> Seiten 234 - 236 <br> I.MIZUMOTO ET AL. 'Low Noise Near <br> Infra-Red Detection System Using InGaAs <br> pin Photodiode' <br> * Abbildung 3 * <br> --- | 1 | |
| A | WO-A-94 00742 (NYCOMED PHARMA) <br> * Zusammenfassung; Abbildungen 1-3 * <br> --- | 1 | |
| A | US-A-5 192 968 (K.KISHIDA ET AL.) <br> * Spalte 1, Zeile 30 - Zeile 32; <br> Abbildungen 1,4,5,8,9,11 * <br> --- | 1 | |
| A | EP-A-0 468 416 (IC-HAUS) <br> * Zusammenfassung; Abbildung 1 * <br> --- | 1 | |
| A | US-A-4 567 363 (M.A.GOODNOUGH) <br> * Zusammenfassung; Abbildungen 1,2,4 * <br> --- | 1 | **RECHERCHIERTE SACHGEBIETE (Int.Cl.6)** <br> G01R <br> G01J <br> H03F |
| A | ELECTRONICS WORLD AND WIRELESS WORLD, <br> Bd.99, Nr.1687, Juni 1993, SURREY GB <br> Seiten 490 - 491 <br> F.OGDEN 'An easier route to light <br> measurement' <br> * Zusammenfassung; Abbildung * <br> ----- | 1 | |

Der vorliegende Recherchenbericht wurde für alle Patentansprüche erstellt

| Recherchenort | Abschlußdatum der Recherche | Prüfer |
|---|---|---|
| BERLIN | 5. Oktober 1994 | Fritz, S |